Europäisches Patentamt

European Patent Office

Office européen des brevets

(11) Veröffentlichungsnummer: **0 393 382 B1**

# EUROPÄISCHE PATENTSCHRIFT

(45) Veröffentlichungstag der Patentschrift: **01.06.94**

(21) Anmeldenummer: **90105616.8**

(22) Anmeldetag: **24.03.90**

(51) Int. Cl.[5]: **G01R 29/08**, G01R 29/12, G01R 15/07, G02F 1/01

(54) **Vorrichtung zum Messen eines eletrischen Feldes.**

(30) Priorität: **07.04.89 CH 1311/89**

(43) Veröffentlichungstag der Anmeldung:
**24.10.90 Patentblatt 90/43**

(45) Bekanntmachung des Hinweises auf die
Patenterteilung:
**01.06.94 Patentblatt 94/22**

(84) Benannte Vertragsstaaten:
**CH DE FR GB IT LI SE**

(56) Entgegenhaltungen:
GB-A- 2 052 053
US-A- 4 533 829

APPLIED OPTICS, Band 27, Nr. 23, 1. Dezember 1988, Seiten 4814-4818, Optical Society of America, New York, US; K.M. BOHNERT et al.: "Fiber-optic sensing of electric field components"

APPLIED PHYSICS LETTERS, Band 50, Nr. 25, 22. Juni 1987, Seiten 1791-1793, American Institute of Physics, New York, US; Y.H. LO et al.: "Proposal for three-dimensional internal field mapping by cw electro-optic probing"

IBM J. RES. DEVELOP., Band 17, Nr. 6, November 1973, Seiten 490-499; M. KALLMEYER et al.: "Rapid, precise, computer-controlled measurement of X-Y coordinates"

Rundfunktechnische Mitteilungen, Jahrgang 27 ( 1983 ), H.4,Seiten 171-178 Dieter Hoff und Karl-Heinz Turkner; " Feldstärkemesssonde zur Beurteilung der Personengefährdung im Nahfeld von leistungs- starken Funksendern "

(73) Patentinhaber: **ASEA BROWN BOVERI AG**
**Haselstrasse**
**CH-5401 Baden(CH)**

(72) Erfinder: **Bohnert, Klaus, Dr.**
**Loonastrasse 9**
**CH-5443 Niederrohrdorf(CH)**
Erfinder: **Nehring, Jürgen, Dr.**
**Neustrasse 47**
**CH-5430 Wettingen(CH)**

## Beschreibung

### Technisches Gebiet

Die Erfindung betrifft eine Vorrichtung zum Messen eines elektrischen Feldes umfassend mindestens einen faseroptischen Sensor, welcher mindestens ein piezoelektrisches Sensorelement, welches mit Hilfe des inversen piezoelektrischen Effekts eine vorgegebene, ihm zugeordnete Richtungskomponente des elektrischen Feldes detektiert, sowie erste Mittel aufweist, welche je ein der zugeordneten Richtungskomponente entsprechendes Sensorsignal erzeugen.

### Stand der Technik

Herkömmliche optische und faseroptische Sensoren zum Messen von elektrischen Feldern beruhen überwiegend auf elektrooptischen Effekten (Pockelseffekt, Kerreffekt). In neuerer Zeit sind nun faseroptische Sensoren entwickelt worden, welche auf dem inversen Piezoeffekt basieren. Diese bekannten Sensoren erzeugen ein Signal, das proportional zur Feldstärke ist. Es ist jedoch nicht möglich, mit den bekannten faseroptischen Sensoren gleichzeitig Richtung und Betrag eines elektrischen Feldes zu detektieren. Vielmehr muss die Feldrichtung im voraus bekannt sein, damit die Feldstärke bestimmt werden kann.

Seit kurzer Zeit ist nun ein faseroptischer Sensor bekannt (z.B. Schweizer Patentgesuch CH-1628/88-2), welcher ausschliesslich eine vorbestimmte Richtungskomponente des Feldes detektiert. Die Richtungskomponente ist durch die Form und den Aufbau des Sensors bestimmt und am Sensor leicht erkennbar (z.B. Flächennormale eines scheibenförmigen Sensorplättchens).

Faseroptische Sensoren haben grundsätzlich den Vorteil, dass sie unempfindlich gegenüber elektrischen und magnetischen Störungen sind. Sie können ausserdem, aufgrund ihrer isolierenden Eigenschaften, in Gegenwart grosser elektrischer Spannungen problemlos eingesetzt werden. Die bei faseroptischen Sensoren benötigte interferometrische Detektion ist heute auf einem hohen technischen Stand. Dies verdeutlicht die nachfolgende Liste von relevanten Druckschriften:
- "Fiber-optic-Fabry-Perot Interferometer and its Sensor Application", T. Yoshino et al. IEEE J. of Quant. Electr. QU-18 1624 (1982),
- "Electric Field Sensitive Optical Fibre Using Piezoelektric Polymer Coating", L.J. Donalds et al. Electr. Lett 18, 327 (1982),
- "Strain effects on higliy elliptical core two-mode fibers", J.N. Blake et al, Optics Letters Vol. 12 No. 9 (1987), S. 732 ff,
- "Use of highly elliptical core fibers for two-mode fiber devices", B.Y. Kim et al, Optics Letters Vo. 12 No. 9 (1987), S. 729 ff.

### Darstellung der Erfindung

Aufgabe der Erfindung ist es, eine Vorrichtung zum Messen eines elektrischen Feldes anzugeben, welche auf faseroptischem Weg gleichzeitig Betrag und Richtung des Feldes ermittelt. Dabei sollen alle Richtungskomponenten mit eine einzigen Sensorkristall detektiert werden.

Diese Aufgabe wird bei einem faseroptischen Sensor der eingangs genannten Art durch die Merkmale des ersten Anspruchs gelöst.

Der Kern der Erfindung liegt darin, dass Symmetrieeigenschaften des inversen piezoelektrischen Effekts derart ausgenutzt werden, dass die Feldkomponenten in z.B. drei zueinander senkrechten Raumrichtungen unabhängig voneinander detektiert werden können. Aus den drei detektierten Feldkomponenten werden dann rechnerisch Betrag und Richtung des wirkenden Feldes ermittelt.

Um eine Richtungskomponente isoliert zu messen, wird an einem geeigneten piezoelektrischen Material eine Glasfaser derart fixiert, dass nur eine der drei Feldkomponenten eine Dimensionsänderung der Glasfaser bewirkt. Eine derart induzierte Längenänderung der Glasfaser ist direkt proportional zum elektrischen Feld und wird interferometrisch gemessen und elektronisch ausgewertet.

Gemäss einer bevorzugten Ausführungsform ist der Sensorkristall quader- oder würfelförmig und besteht aus einem Material einer der Kristallklassen $T$, $T_d$, $D_2$, $D_{2d}$, d.h. er weist drei 2-zählige kristallographische Drehachsen auf. Diese sind parallel zu seinen Kanten orientiert. Auf senkrecht zueinander ausgerichteten Flächen sind jeweils die Sensorfasern fixiert. Die mindestens zwei Sensorelemente werden somit durch senkrecht zueinander stehende Flächen des quaderförmigen, piezoelektrischen Körpers gebildet.

Die interferometrischen Mittel umfassen z.B Mach-Zehnder-Interferometer, faseroptische Fabry-Perots, Zweimoden-Interferometer u.ä.

Aus den abhängigen Patentansprüchen geht eine grosse Zahl von bevorzugten Ausführungsformen hervor.

**Kurze Beschreibung der Zeichnung**

Nachfolgend soll die Erfindung anhand von Ausführungsbeispielen im Zusammenhang mit der Zeichnung näher erläutert werden. Es zeigen:

Fig. 1      eine schematische Darstellung einer Vorrichtung zum Messen von Betrag und Richtung eines elektrischen Feldes;

Fig. 2      eine schematische Darstellung eines faseroptischen Sensors;

Fig. 3      ein piezoelektrisches Sensorelement, welches ausschliesslich eine Richtungskomponente des elektrischen Feldes parallel zur Glasfaser detektiert;

Fig. 4      ein piezoelektrisches Sensorelement, welches ausschliesslich eine Richtungskomponente des elektrischen Feldes senkrecht zur Glasfaser detektiert;

Fig. 5      eine Schaltanordnung zum Auswerten der Sensorsignale;

Fig. 6      eine Darstellung der räumlichen Beziehungen, welche bei der Auswertung der Sensorsignale benutzt werden; und

Fig. 7      eine schematische Darstellung einer bevorzugten Ausführungsform der Erfindung, bei welcher die drei Feldkomponenten mit einem einzigen Sensorkristall detektiert werden.

Die in der Zeichnung verwendeten Bezugszeichen und deren Bedeutung sind in der Bezeichnungsliste zusammenfassend tabelliert.

**Wege zur Ausführung der Erfindung**

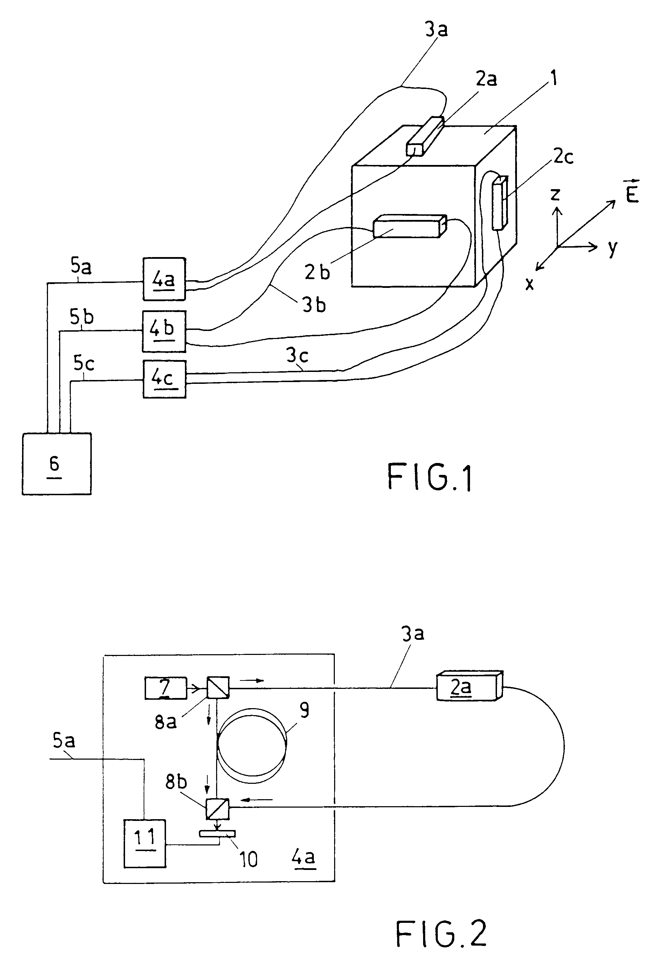

Fig. 1 zeigt eine schematische Darstellung einer erfindungsgemässen Vorrichtung zum gleichzeitigen Messen von Betrag und Richtung eines elektrischen Feldes E.

Auf einem Träger 1, z.B. einem quader- oder würfelförmigen und nicht-piezoelektrischen Körper, sind drei piezoelektrische Sensorelemente 2a, 2b, 2c befestigt. Jedes der drei Sensorelemente 2a, 2b, 2c ist so ausgebildet, dass es nur für eine vorgegebene, ihm zugeordnete Richtungskomponente des elektrischen Feldes E empfindlich ist. Die piezoelektrischen Sensorelemente 2a, 2b, 2c wiederum sind so auf dem Träger 1 angeordnet, dass die drei Richtungskomponenten paarweise senkrecht zueinander ausgerichtet sind.

An jedem Sensorelement 2a, 2b, 2c ist eine Sensorfaser 3a, 3b, 3c jeweils mit einem gegebenen Längenabschnitt fixiert. Jede Sensorfaser 3a, 3b, 3c ist an je einem Detektor 4a, 4b, 4c angeschlossen. Jeder der drei Detektoren 4a, 4b, 4c detektiert interferometrisch eine durch das piezoelektrische Sensorelement 2a, 2b, 2c (entsprechend den Feldkomponenten des wirkenden elektrischen Feldes E) hervorgerufene Längenänderung der entsprechenden Sensorfaser 3a, 3b, 3c und erzeugt ein entsprechendes Ausgangssignal. Dieses wird jeweils über einen Detektorausgang 5a, 5b, 5c an eine Auswerteschaltung 6 weitergegeben.

Die Auswerteschaltung 6 ermittelt aus den Sensorsignalen Betrag und Richtung des elektrischen Feldes E und bringt diese in gewünschter Weise, beispielsweise auf einem Display, zur Anzeige. Die ermittelten Grössen (Betrag, Richtung) können je nach Anwendungsgebiet auch über einen in der Leittechnik gebräuchlichen Busanschluss (in Fig. 1 nicht gezeigt) an eine Ueberwachungsstation weitergegeben werden.

Im folgenden werden nun faseroptischer Sensor und piezoelektrisches Sensorelement beschrieben. Grundsätzlich sind die zum Messen einer bestimmten Richtungskomponente vorgesehenen Mittel für alle drei Raumrichtungen analog aufgebaut. Was also z.B. für das Sensorelement 2a gesagt wird gilt entsprechend für die andern beiden Sensorelemente 2b und 2c.

Fig. 2 zeigt eine schematische Darstellung eines faseroptischen Sensors zum Messen einer vorgegebenen Richtungskomponente des elektrischen Feldes E. Er umfasst unter anderem folgende, bereits in Fig. 1 gezeigten Teile: Piezoelektrisches Sensorelement 2a, Sensorfaser 3a, und Detektor 4a. Als interferometrisches Mittel zum Detektieren einer Längenänderung der Sensorfaser 3a dient eine Mach-Zehnder-Anordnung.

Das als solches bekannte Mach-Zehnder-Interferometer ist wegen seiner grossen Empfindlichkeit besonders vorteilhaft. Es stellt jedoch keineswegs die einzig mögliche Ausführungsform dar.

EP 0 393 382 B1

Ein Laser 7 erzeugt einen hinreichend kohärenten Strahl, welcher in einem ersten Strahlteiler 8a in zwei Teilstrahlen aufgeteilt wird. Einer der Teilstrahlen wird in die Sensorfaser 3a eingekoppelt und erfährt beim Anlegen eines elektrischen Feldes im Sensorelement 2a eine der Stärke der vorgegebenen Richtungskomponente des elektrischen Feldes E proportionale Phasenschiebung. Der zweite Teilstrahl wird in eine Referenzfaser 9 eingekoppelt.

In einem zweiten Strahlteiler 8b werden die beiden Teilstrahlen aus Sensorfaser 3a und Referenzfaser 9 zu einem Interferenzstrahl vereinigt, welcher dann von einem Photodetektor 10 aufgefangen wird. Ein Verstärker 11 erzeugt aus dem Photostrom des Photodetektors 10 ein der Intensität des Interferenzstrahls proportionales Ausgangssignal.

Wie bereits gesagt ist die faseroptische Mach-Zehnder-Anordnung als solche bekannt. Der Detektor bedarf deshalb hier keiner ausführlichen Erläuterung.

Ein richtungsempfindliches, piezoelektrisches Sensorelement ist als solches bereits im eingangs zitierten Patentgesuch CH-1628/88-2 offenbart. Der Vollständigkeit halber werden aber nachfolgend einige vorteilhafte Ausführungsformen des Sensorelements 2a beschrieben.

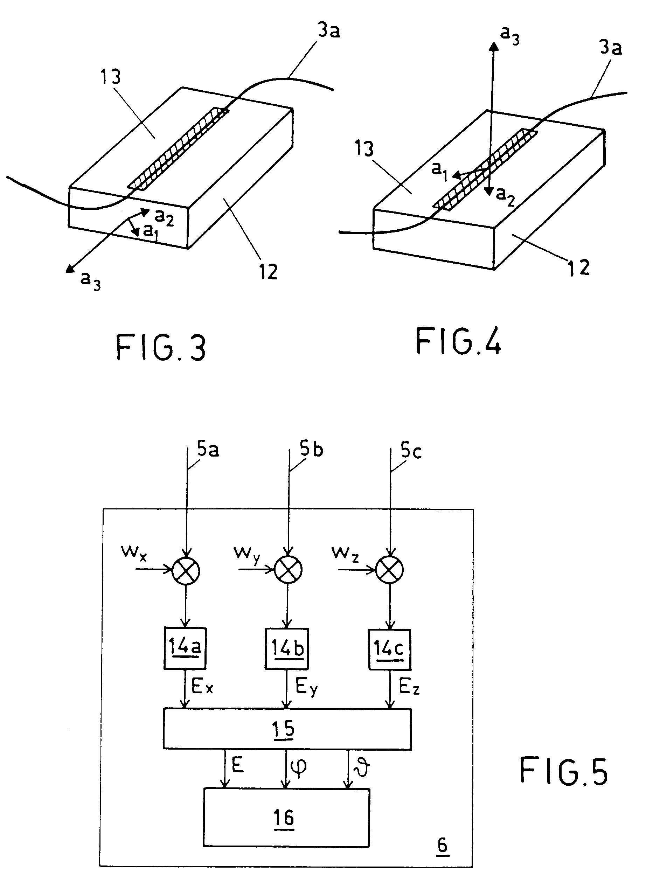

Fig. 3 zeigt ein Sensorelement, welches eine vorgegebene Richtungskomponente parallel zur Sensorfaser 3a detektiert. Die Sensorfaser 3a ist mit einem gegebenen Längenabschnitt (siehe Schraffur) auf einer Hauptfläche 13 eines piezoelektrischen Körpers 12 fixiert. Der Körper 12 hat z.B. die Form eines Plättchens und weist eine bestimmte kristallografische Orientierung auf, definiert durch drei orthogonale Achsen $a_1$, $a_2$, $a_3$. Die Achse $a_3$ bezeichnet die Raumrichtung, in welcher das Sensorelement empfindlich ist. Dies bedeutet, dass nur eine Richtungskomponente des elektrischen Feldes zu einem Sensorsignal führen kann, welche parallel zur Achse $a_3$ liegt. Voraussetzung dafür ist, dass eine der in Tabelle I aufgeführten Bedingungen erfüllt ist:

Tabelle I

| Kristallklassen (Schoenflies [international]) | Drehachse parallel zur Glasfaser |
|---|---|
| C2 [2] | 2-zählige Achse |
| C2v [2mm] | 2-zählige Achse |
| C3 [3] | 3-zählige Achse |
| C3v [3m] | 3-zählige Achse |
| D3 [32] | 2-zählige Achse |
| D3h [$\overline{6}$2m] | 2-zählige Achse |
| C4 [4] | 4-zählige Achse |
| C6 [6] | 6-zählige Achse |
| C∞ [∞] | ∞-zählige Achse |
| C4v [4mm] | 4-zählige Achse |
| C6v [6mm] | 6-zählige Achse |
| C∞v [∞mm] | ∞-zählige Achse |
| T [23] | 3-zählige Achse |
| Td [$\overline{4}$3m] | 3-zählige Achse |

In der linken Kolonne der Tabelle sind die Kristallklassen (in Schoenflies resp. internationaler Notation) aufgeführt, für welche die Ausführungsform gemäss Fig. 3 geeignet ist, und in der rechten Kolonne ist angegeben, welche kristallografische Drehachse eines zur entsprechenden Kristallklasse gehörenden Körpers im wesentlichen parallel zur Achse $a_3$, d.h. parallel zur Sensorfaser, liegen muss.

Weitere einschränkende Bedingungen bezüglich der Achsen $a_1$ und $a_2$ gibt es bei den Ausführungsformen gemäss Fig. 3 nicht.

Wenn nun in der in Fig. 1 gezeigten Vorrichtung piezoelektrische Sensorelemente gemäss Fig. 3 verwendet werden und diese jeweils parallel zu einer der drei von einem Eckpunkt ausgehenden Kanten des quaderförmigen Trägers 1 ausgerichtet sind, dann detektiert das Sensorelement 2a die Richtungskomponente in x-Richtung, das Sensorelement 2b diejenige in y-Richtung und das Sensorelement 2c diejenige in z-Richtung. Das Koordinatensystem x, y, z (siehe Fig. 1) wird somit definiert durch drei je orthogonale Kanten des Trägers 1.

Fig. 4 zeigt eine weitere Klasse von Sensorelementen. Hier steht die vorgegebene Richtungskomponente senkrecht zur Sensorfaser 3a. Der Einfachheit halber ist auch hier der piezoelektrische Körper 12 plättchenförmig. Wie in Fig. 3 ist die Sensorfaser 3a mit einem gegebenen Längenabschnitt auf einer Hauptfläche 13 des Körpers 12 fixiert.

4

Anders als bei der in Fig. 3 gezeigten Ausführungsform ist die kristallografische Orientierung. Die Achse $a_3$ steht senkrecht zur Hauptfläche 13. Die andern beiden Achsen $a_1$ und $a_2$ sind vorzugsweise so ausgerichtet, dass sie einen 45° Winkel mit der Sensorfaser 3a einschliessen. In anderen Worten: Die Sensorfaser 3a liegt auf einer Winkelhalbierenden der beiden Achsen $a_1$ und $a_2$. Die Bedingungen für die kristallografische Orientierung sind in der Tabelle II zusammengestellt.

Tabelle II

| Kristallklassen (Schoenflies [international]) | Drehachse ∥ resp. ⊥ zur vorbestimmten Richtungskomponente | Richtung der Sensorfaser für maximale Dehnung |
|---|---|---|
| D2 [222] | ∥ 2-zählige Achse | 45° bezgl. 2-zählige Achse |
| D2d [$\bar{4}$2m] | ∥ 2-zählige Achse | 45° bezgl. 2-zählige Achse |
| T [23] | ∥ 2-zählige Achse | 45° bezgl. 2-zählige Achse |
| Td [$\bar{4}$3m] | ∥ $\bar{4}$-zählige Achse | 45° bezgl. $\bar{4}$-zählige Achse |
| D4 [422] | ⊥ 4-zählige Achse | 45° bezgl. 4-zählige Achse |
| D6 [622] | ⊥ 6-zählige Achse | 45° bezgl. 6-zählige Achse |
| D∞ [∞22] | ⊥ ∞-zählige Achse | 45° bezgl. ∞-zählige Achse |

Die ersten beiden Kolonnen von Tabelle II geben einige mögliche Kristallklassen (in Schoeflies resp. internationaler Notation) an, welche für die Ausführungsform gemäss Fig. 4 geeignet sind. Die dritte Kolonne gibt an, welche kristallografische Drehachse parallel oder senkrecht zur Achse $a_3$ liegen muss. In der vierten Kolonne ist angegeben, wie die Sensorfaser 3a bezogen auf eine bestimmte Drehachse ausgerichtet werden soll, um bei gegebener Feldstärke ein maximales Sensorsignal zu erhalten. Andere Ausrichtungen der Sensorfaser 3a sind also nicht etwa unzulässig, sondern führen nur zu einer geringeren Dehnung der Sensorfaser. Dies kommt daher, dass der inverse piezoelektrische Effekt eine Scherung des Plättchens um eine zur Hauptfläche senkrechte Achse induziert und dass diese Scherung für eine geeignete Ausrichtung der Glasfaser zu einer maximalen Längenänderung derselben führt.

Werden in der Vorrichtung gemäss Fig. 1 Sensorelemente gemäss Fig. 4 verwendet, wobei die Hauptfläche 13 jedes piezoelektrischen Körpers 12 jeweils parallel zur entsprechenden Fläche des Trägers 1 ausgerichtet ist, so detektiert jedes Sensorelement 2a, 2b, 2c eine zur Fläche des Trägers 1, auf welcher es fixiert ist, senkrechte Richtungskomponente des elektrischen Feldes E. Das den Raum aufspannende Koordinatensystem wird also durch drei orthogonale Flächennormalen des Trägers 1 definiert. Die plättchenförmigen Sensorelemente brauchen demnach nicht parallel zu einer Kante des Trägers 1 ausgerichtet zu sein.

Wie bereits gesagt gibt es für die piezoelektrischen Sensorelemente noch eine grosse Zahl weiterer Ausführungsformen. Es soll an dieser Stelle genügen, nochmals ausdrücklich auf das Patentgesuch CH-1628/88-2 zu verweisen.

Als nächstes wird die Auswerteschaltung 6 näher erläutert. Ohne Einschränkung der Allgemeinheit wird angenommen, dass an den Detektorausgängen 5a, 5b und 5c je die Sensorsignale entsprechend der Richtungskomponente des Feldes in x-, y- und z-Richtung anliegen (siehe Fig. 1).

In der Auswerteschaltung werden als erstes die Sensorsignale mit geeigneten Gewichten $w_x$, $w_y$, $w_z$ multipliziert. Damit kann eine unterschiedliche Empfindlichkeit der drei faseroptischen Sensoren ausgeglichen werden.

Als nächstes wird jedes der drei gewichteten Sensorsignale in je einem Kompensator 14a, 14b, 14c ausgewertet und in je ein digitales Signal $E_x$, $E_y$, $E_z$ umgewandelt, welches die Grösse der jeweiligen Richtungskomponente des elektrischen Feldes wiedergibt. Die Kompensatoren 14a, 14b, 14c tragen einerseits allfälligen Nichtlinearitäten der interferometrichen Anordnung (Abhängigkeit der Intensität des Interferenzstrahls von der Phasenschiebung des Teilstrahls) Rechnung und andererseits dem durch die piezoelektrischen Koeffizienten diktierten linearen Zusammenhang zwischen Feldstärke und relativer Längenänderung der Sensorfaser.

Aus den digitalen Signalen $E_x$, $E_y$, $E_z$ werden in einem Rechner 15 Betrag $|E|$ und Richtung, definiert durch die Winkel $\phi$ und $\Theta$, errechnet und z.B. auf einem Display ausgegeben.

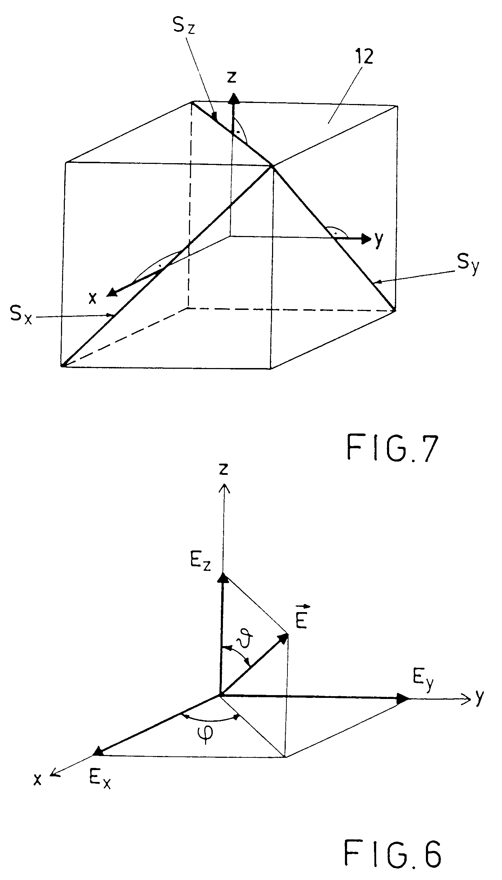

Fig. 6 veranschaulicht die räumlichen Beziehungen, welche bei der Auswertung im Rechner 15 benutzt werden. Als Basis wird ein Koordinatensystem x, y, z verwendet, wie es durch die von den Sensorelementen 2a, 2b, 2c gegebenen Richtungskomponenten gemäss Fig. 1 aufgespannt wird. Wenn die Komponenten des elektrischen Feldes gegeben sind durch die digitalen Signale $E_x$, $E_y$, $E_z$, so ist der Betrag $|E|$ der Feldstärke bekanntlich gegeben durch:

$$|E| = \sqrt{E_x^2 + E_y^2 + E_z^2} \qquad (I)$$

Zur Bestimmung der Richtung des elektrischen Feldes müssen auch die Vorzeichen der Richtungskomponenten berücksichtigt werden. Falls das elektrische Feld einen sinusförmigen zeitlichen Verlauf hat, ist die Information über die Vorzeichen in der Phasenlage der Sensorsignale enthalten, welche entweder 0° oder 180° ist. Es ist natürlich von Vorteil, wenn die Sensoren so gestaltet sind, dass sie für eine positive Richtungskomponente alle auch je ein positives Sensorsignal (positives Vorzeichen) liefern. Dies ist eine Vorkehrung, welche die Realisierung der Auswerteschaltung transparenter erscheinen lässt. In keiner Weise ist sie aber von grundsätzlicher Bedeutung.

Bezeichnet der Winkel $\Theta$ den vom Feld E mit der z-Richtung eingeschlossenen Winkel und der Winkel $\phi$ denjenigen zwischen einer Normalprojektion des Feldes E in die x-y-Ebene und der x-Richtung (siehe Fig. 6), so gelten folgende Beziehungen:

$$\phi = \arctan (E_y/E_x) \text{ falls } E_x \text{ positiv} \qquad (II)$$

$$\phi = \arctan (E_y/E_x) + 180° \text{ falls } E_x \text{ negativ} \qquad (III)$$

$$\Theta = \arctan (\sqrt{E_x^2 + E_y^2} / E_z) \text{ falls } E_z) \text{ positiv} \qquad (IV)$$

$$\Theta = \arctan (\sqrt{E_x^2 + E_y^2} / E_z) + 180° \text{ falls } E_z \text{ negativ} \qquad (V)$$

Diese mathematischen Operationen werden im Rechner 15, z.B. einem als solchen bekannten Mikroprozessor, ausgewertet.

Im folgenden wird eine weitere, besonders bevorzugte Ausführungsform der Erfindung beschrieben. Bei dieser werden alle drei Richtungskomponenten durch einen einzigen piezoelektrischen Körper detektiert.

Fig. 7 zeigt ein entsprechendes Sensorelement mit einem würfelförmigen piezoelektrischen Körper 12. Dieser besteht aus einem Material, welches einer der vier Kristallklassen T, $T_d$, $D_2$ und $D_{2d}$ angehört. Die kristallografische Orientierung ist dergestalt, dass die drei von einer Ecke ausgehenden Kanten des piezoelektrischen Körpers 12 je parallel zu einer 2-zähligen Drehachse verlaufen. Dadurch führen die Richtungskomponenten des elektrischen Feldes zu einer Scherung der jeweils dazu senkrechten Fläche des würfelförmigen Körpers 12. Die vorgegebenen Richtungskomponenten stehen also senkrecht zu den entsprechenden Flächen und definieren ein Koordinatensystem x, y, z analog zur Ausführungsform gemäss Fig. 1 in Verbindung mit Fig. 4.

Die Sensorfasern 3a, 3b, 3c werden nun vorzugsweise auf einer Flächendiagonalen am piezoelektrischen Körper 12 fixiert. Auf diese Weise ergibt sich eine maximale Empfindlichkeit. Einerseits ist nämlich die relative Längenänderung $\delta L/L$ der Sensorfaser maximal und andererseits ist natürlich auch die totale Längenänderung auf der Flächendiagonalen (fixierter Längenabschnitt x relative Längenänderung) maximal.

Konkret sieht das in Fig. 7 so aus, dass die Sensorfaser 3a auf einer Flächendiagonalen $s_x$ verläuft und somit eine Richtungskomponente in x-Richtung detektiert, die Sensorfaser 3b auf einer Flächendiagonalen $s_y$ verläuft und somit eine Richtungskomponente in y-Richtung detektiert und dass die Sensorfaser 3c auf einer Flächendiagonalen $s_z$ verläuft und somit eine Richtungskomponente in z-Richtung detektiert.

Es versteht sich, dass für jede der drei Sensorfasern 3a, 3b, 3c separate interferometrische Mittel vorgesehen sind und dass die Auswertung analog zu Fig. 1 in Verbindung mit Fig. 5 erfolgt.

Im vorliegenden Beispiel bildet die Normalprojektion der Flächendiagonalen $s_x$ auf die y-z-Ebene die positive Winkelhalbierende (die Winkelhalbierende des I. und III. Quadranten in einem Koordinatensystem aufgespannt durch y- und z-Richtung). Entsprechendes gilt für die anderen beiden Flächendiagonalen $s_y$ und $s_z$. Eine solche Ausrichtung hat zur Folge, dass für alle Richtungskomponenten eine Phasenlage des Sensorsignals von 180° ein negatives Vorzeichen anzeigt, falls die entsprechenden piezoelektrischen Dehnungskoeffizienten $d_{ij}$ positiv sind. Wenn die entsprechenden Dehnungskoeffizienten negativ sind, wird der genannte Zusammenhang einfach invertiert.

Für die Kristallklassen T und $T_d$ ist die Phasenlage (im Fall der positiven Winkelhalbierenden) für alle drei Richtungskomponenten stets gleich, kann aber die Werte 0° oder 180° annehmen, abhängig davon, ob die Dehnungskoeffizienten $d_{ij}$ positiv oder negativ sind. Für die Kristallklassen $D_2$ und $D_{2d}$ ist die Phasenlage der drei Sensorsignale nur dann gleich, falls alle Dehnungskoeffizienten $d_{ij}$ gleiches Vorzeichen haben, was aber aus Symmetriegründen nicht der Fall sein muss.

Die Flächendiagonalen $s_x$. $s_y$, $s_z$ können natürlich ebensogut in Richtung der negativen Winkelhalbierenden (Winkelhalbierende des II. und IV. Quadranten) verlaufen. Dadurch wird einfach der oben beschriebene Zusammenhang zwischen Vorzeichen und Phasenlage invertiert.

Wie bereits angedeutet brauchen die Sensorfasern 3a, 3b, 3c nicht unbedingt auf einer Flächendiagonalen am piezoelektrischen Körper befestigt zu sein. Sie können durchaus auch in einer anderen Richtung verlaufen. Die relative Längenänderung $\delta L/L$, die aufgrund des inversen piezoelektrischen Effekts induziert wird, ist dann (bei gleicher elektrischer Feldstärke) natürlich geringer. Es ist somit auch klar, dass der piezoelektrische Körper 12 statt würfelförmig auch quaderförmig sein darf.

Wenn nun aber bei einem quaderförmigen Körper die Sensorfasern auf den Flächendiagonalen verlaufen, so ergibt sich für die verschiedenen Richtungskomponenten im allgemeinen eine unterschiedliche Empfindlichkeit. Aus den obigen Erläuterungen ergibt sich nämlich, dass ein elektrisches Feld gegebener Stärke in x-Richtung nicht zum gleich grossen Sensorsignal führt, wie ein elektrisches Feld gleicher Stärke in y-Richtung. Diese unterschiedliche Empfindlichkeit kann z.B. mit geeigneten Gewichten $w_x$, $w_y$, $w_z$ in der Auswerteschaltung 6 ausgeglichen werden.

Als nächstes wird aufgezeigt, wie die relative Längenänderung der Sensorfaser (und entsprechend das Sensorsignal) vom elektrischen Feld abhängt.

Die Matrizen der piezoelektrischen Dehnungskoeffizienten lauten für die Kristallklassen T, $T_d$, $D_2$, $D_{2d}$ bekanntlich wie folgt:

T, $T_d$

$$\begin{bmatrix} 0 & 0 & 0 & d_{14} & 0 & 0 \\ 0 & 0 & 0 & 0 & d_{14} & 0 \\ 0 & 0 & 0 & 0 & 0 & d_{14} \end{bmatrix}$$

$D_{2d}$

$$\begin{bmatrix} 0 & 0 & 0 & d_{14} & 0 & 0 \\ 0 & 0 & 0 & 0 & d_{14} & 0 \\ 0 & 0 & 0 & 0 & 0 & d_{36} \end{bmatrix}$$

$D_2$

$$\begin{bmatrix} 0 & 0 & 0 & d_{14} & 0 & 0 \\ 0 & 0 & 0 & 0 & d_{25} & 0 \\ 0 & 0 & 0 & 0 & 0 & d_{36} \end{bmatrix}$$

Die besonders bevorzugte Ausführungsform mit nur einem piezoelektrischen Körper beruht also darauf, dass bei den vier genannten Symmetriegruppen nur je drei Scherbewegungen bezüglich dreier zueinander je senkrechter Achsen möglich sind. Bei diesen Achsen handelt es sich jeweils um die zweizähligen kristallografischen Drehachsen. Jede dieser Scherbewegungen wird ausschliesslich durch die Feldkomponente parallel zur entsprechenden Scherachse (Kristallachse) hervorgerufen.

Der durch die Matrizen der piezoelektrischen Dehnungskoeffizienten diktierte Zusammenhang zwischen elektrischem Feld und relativer Längenänderung ist hinlänglich bekannt. (Die hier verwendete Bezeichnung der kristallographischen Achsen entspricht der Konvention, wie sie z.B. im Buch "Physical Properties of Crystals" J.F. Nye, Oxford University Press, 1967, beschrieben ist). Für die Kristallklassen T und $T_d$ beispielsweise gilt demzufolge nachstehender Zusammenhang zwischen digitalem Signal $E_x$ und relativer Längenänderung $\delta L/L$:

$$\delta L/L = d_{14} E_x \qquad (VI)$$

Analoges gilt für die andern Richtungskomponenten.

7

Für Materialien der Kristallklassen T und $T_d$ ist die Ausführungsform mit dem würfelförmigen piezoelektrischen Körper besonders vorteilhaft, da alle drei Richtungskomponten mit gleicher Empfindlichkeit gemessen werden. Die relevanten Dehnungskoeffizienten sind nämlich alle gleich gross.

Wie bereits gesagt kann der unterschiedlichen Empfindlichkeit der Richtungskomponenten im Fall der Kristallklassen $D_2$, $D_{2d}$ in der Auswerteschaltung entsprechend Rechnung getragen werden. Eine andere Möglichkeit besteht darin, dass die Richtung, in welcher die jeweilige Sensorfaser auf der Fläche des piezoelektrischen Körpers fixiert wird, gerade so gewählt ist, dass der Einfluss der unterschiedlichen Dehnungskoeffizienten geometrisch kompensiert wird.

Materialien, die sich für die in Fig. 7 gezeigte Ausführungsform besonders gut eignen, sind u.a. folgende:

T: Wismuth-Germaniumoxid $Bi_{12}GeO_{20}$, Natriumchlorat $NaClO_3$, Ammoniumsulfat $(NH_4)_2Mn_2(SO_4)_3$, Kaliumsulfat $K_2Mn_2(SO_4)_3$, Rubidiumsulfat $Rb_2Mn_2(SO_4)_3$, u.a.m.

$T_d$: III-V-Verbindungshalbleiter wie z.B. GaAs, InAs, InP, ZnSe, GaP.

$D_2$: Rochelle Salz $KNaC_4H_4O_6 \times 4H_2O$, Iodische Säure $HIO_3$ u.a.m.

$D_{2d}$: Kaliumphosphat (KDP), Ammoniumphosphat (ADP), Rubidiumphosphat (RDP).

GaAs nimmt dabei eine bevorzugte Stellung ein, da die Herstellungstechnologie weit fortgeschritten ist.

Die Erfindung beschränkt sich natürlich nicht auf die beschriebenen Ausführungsbeispiele. Dies ergibt sich auch aus den nachfolgenden Hinweisen auf weitere Ausführungsformen.

Das Mach-Zehnder-Interferometer kann zur Erhöhung des Messbereichs z.B. auch mit Kompensation im Referenzpfad betrieben werden. Ebenso können bei Bedarf auch Mittel für die Heterodyndetektion vorgesehen sein.

Statt des Mach-Zehnder-Interferometers eignen sich wegen ihrer grossen Auflösung auch Fabry-Perot-Interferometer. Dabei ist die am piezoelektrischen Körper fixierte Sensorfaser als faseroptisches Fabry-Perot ausgebildet, dessen Transmission oder Reflexion gemessen wird.

U.u. können auch Zweimoden-Interferometer eingesetzt werden. Hier kann die an sich geringe Empfindlichkeit des Interferometers durch einen möglichst grossen, am piezoelektrischen Körper fixierten Längenabschnitt der Sensorfaser kompensiert werden.

Die Empfindlichkeit des faseroptischen Sensors hängt natürlich wesentlich davon ab, wie gross der am Körper fixierte Längenabschnitt ist. Die Flächendiagonale bietet diesbezüglich das Maximum. Da ein quaderförmiger Körper aber stets zwei einander völlig korrespondierende Flächen besitzt, kann jede Sensorfaser über zwei Flächendiagonalen geführt und fixiert werden. Allein dadurch verdoppelt sich die Empfindlichkeit. Eine weitere Steigerung ergibt sich, wenn die Sensorfaser mehrmals um den Körper gewickelt wird, wobei sie auf der entsprechenden Fläche in mehreren, parallel zueinander liegenden Längenabschnitten fixiert ist.

Im allgemeinen hat das Sensorsignal ein sinusförmiges Grossignalverhalten. Wenn sich die durch den inversen Piezoeffekt induzierte Variation der Phase des Teilstrahls im Bereich von etwa +/- 0.1 rad bewegt, so reicht es völlig aus, wenn in diesem Bereich das sinusförmige Signalverhalten durch eine lineare Approximation ersetzt wird. Dies hat dann eine besonders einfache Ausführung der Kompensatoren zur Folge.

Die Auswerteschaltung lässt sich sehr einfach realisieren, wenn gleich an den Eingängen die Sensorsignale digitalisiert und alle nachfolgenden Operationen mit einem als solchen bekannten Mikroprozessor durchgeführt werden.

Wenn bisher stets von drei Richtungskomponenten gesprochen wurde, so bedeutet das nicht, dass eine "reduzierte" Ausführungsform mit nur zwei richtungsempfindlichen Sensorelementen von der Erfindung nicht abgedeckt wird. Ebenso können gemäss der Erfindung redundante Ausführungsformen mit mehr als drei Richtungskomponenten realisiert werden.

Insgesamt schafft die Erfindung eine sehr kompakte und vielseitig anwendbare Vorrichtung zum gleichzeitigen Messen von Betrag und Richtung eines elektrischen Feldes.

**Patentansprüche**

**1.** Vorrichtung zum Messen eines elektrischen Feldes umfassend mindestens einen faseroptischen Sensor, welcher

a) mindestens ein piezoelektrisches Sensorelement (2a-c), welches mit Hilfe des inversen piezoelektrischen Effekts ausschliesslich eine vorgegebene, ihm zugeordnete Richtungskomponente des elektrischen Feldes detektiert, sowie

b) erste Mittel (4a-c) aufweist, welche je ein der zugeordneten Richtungskomponente entsprechendes Sensorsignal erzeugen;

dadurch gekennzeichnet, dass

c) zum Messen von Betrag und Richtung des elektrischen Feldes mindestens zwei faseroptische Sensoren vorgesehen sind, wobei die den piezoelektrischen Sensorelementen (2a-c) zugeordneten Richtungskomponenten je senkrecht zueinander ausgerichtet sind;

d) zweite Mittel (6) vorgesehen sind, welche aus den erzeugten Sensorsignalen Betrag und Richtung des elektrischen Feldes ermitteln;

e) die mindestens zwei Sensorelemente (2a-c) durch senkrecht zueinander stehende Flächen eines quaderförmigen piezoelektrischen Körpers gebildet werden, welcher Körper aus einem Material einer der Kristallklassen T, $T_d$, $D_2$, $D_{2d}$ besteht und somit drei 2-zählige kristallographische Drehachsen aufweist, und welcher mit seinen Kanten parallel zu den 2-zähligen kristallographischen Drehachsen ausgerichtet ist; sowie

f) die ersten Mittel zum Erzeugen der Sensorsignale eine mit einem Längenabschnitt an einer Fläche des piezoelektrischen Körpers (12) fixierte Sensorfaser (3a-c) und interferometrische Mittel zum Messen einer durch den inversen piezoelektrischen Effekt induzierten Längenänderung der Sensorfaser umfassen, so dass die Richtungskomponenten jeweils mit einer Flächennormalen zusammenfallen.

2. Vorrichtung nach Anspruch 1, dadurch gekennzeichnet, dass der piezoelektrische Körper (12) würfelförmig ist.

3. Vorrichtung nach Anspruch 1, dadurch gekennzeichnet, dass die Sensorfasern (3a-c) parallel zu einer Flächendiagonalen des piezoelektrischen Körpers (12) fixiert ist.

4. Vorrichtung nach Anspruch 1, dadurch gekennzeichnet, dass das Material ein III-V-Verbindungshalbleiter ist.

5. Vorrichtung nach Anspruch 4, dadurch gekennzeichnet, dass das Material ein Kristall aus einer Gruppe umfassen GaAs, InAs, InP, ZnSe, GaP ist.

6. Vorrichtung nach Anspruch 1, dadurch gekennzeichnet, dass das Material eine Kristall aus einer Gruppe umfassend KDP, RDP, ADP ist.

7. Vorrichtung nach Anspruch 1, dadurch gekennzeichnet, dass die interferometrischen Mittel ein Mach-Zehnder-Interferometer umfassen.

8. Vorrichtung nach Anspruch 1, dadurch gekennzeichnet, dass genau drei, mit den zugeordneten Richtungskomponenten je senkrecht zueinander stehende piezoelektrische Sensorelemente vorgesehen sind.

## Claims

1. Device for measuring an electric field, comprising at least one optical fibre sensor, which

a) has at least one piezoelectric sensor element (2a-c) that exclusively detects with the aid of the inverse piezoelectric effect a predetermined directional component, assigned to it, of the electric field, as well as

b) first means (4a-c) that generate a sensor signal corresponding in each case to the assigned directional component;

characterized in that

c) at least two optical fibre sensors are provided for measuring the absolute value and direction of the electric field, the directional components assigned to the piezoelectric sensor elements (2a-c) being aligned perpendicular to one another in each case;

d) second means (6) are provided which determine the absolute value and direction of the electric field from the sensor signals generated;

e) the at least two sensor elements (2a-c) are formed by mutually perpendicular faces of a cuboid piezoelectric body, which body consists of a material of one of the crystal classes T, $T_d$, $D_2$, $D_{2d}$, and thus has three 2-fold crystallographic axes of rotation, and which is aligned with its edges parallel to the 2-fold crystallographic axes of rotation; as well as

f) the first means for generating the sensor signals comprise a sensor fibre (3a-c) fixed with a section of length to a face of the piezoelectric body (12), and interferometric means for measuring a change in length of the sensor fibre induced by the inverse piezoelectric effect, so that the directional components coincide with a surface normal in each case.

2. Device according to Claim 1, characterized in that the piezoelectric body (12) is cube-shaped.

3. Device according to Claim 1, characterized in that the sensor fibres (3a-c) is [sic] fixed parallel to a face diagonal of the piezoelectric body (12).

4. Device according to Claim 1, characterized in that the material is a III-V compound semiconductor.

5. Device according to Claim 4, characterized in that the material is a crystal from a group comprise [sic] GaAs, InAs, InP, ZnSe, GaP.

6. Device according to Claim 1, characterized in that the material is a crystal from a group comprising potassium dihydrogen phosphate, rubidium dihydrogen phosphate, ammonium dihydrogen phosphate.

7. Device according to Claim 1, characterized in that the interferometric means comprise a Mach-Zehnder interferometer.

8. Device according to Claim 1, characterized in that precisely three piezoelectric sensor elements, mutually perpendicular in each case, are provided with the assigned directional components.

**Revendications**

1. Dispositif de mesure d'un champ électrique, comprenant au moins un capteur à fibres optiques, qui
a) a au moins un élément piézoélectrique de détection (2a-c) qui détecte exclusivement à l'aide de l'effet piézoélectrique inverse une composante directionnelle prédéterminée, qui lui est assignée, du champ électrique, ainsi que
b) des premiers moyens (4a-c) qui génèrent un signal de capteur correspondant dans chaque cas à la composante directionnelle assignée;
caractérisé en ce que
c) au moins deux capteurs à fibres optiques sont fournis pour mesurer la valeur absolue et la direction du champ électrique, les composantes directionnelles assignées aux éléments piézoélectriques de détection (2a-c) étant alignées perpendiculairement l'une à l'autre dans chaque cas;
d) des second moyens (6) sont fournis pour déterminer la valeur absolue et la direction du champ électrique à partir des signaux de capteur générés;
e) les au moins deux éléments de détection (2a-c) sont formés par des faces mutuellement perpendiculaires d'un corps piézoélectrique cuboïde, lequel corps consiste en un matériau de l'une des classes de quartz T, $T_d$, $D_2$, $D_{2d}$, et a donc trois axes cristallographiques de rotation d'ordre 2, et qui est aligné avec ses bords parallèles aux axes cristallographiques de rotation d'ordre 2; ainsi que
f) les premiers moyens pour générer les signaux de capteur comprennent une fibre de détection (3a-c) fixée avec une section de longueur à une face du corps piézoélectrique (12), et un moyen interférométrique pour mesurer un changement de longueur de la fibre de détection causé par l'effet piézoélectrique inverse, de sorte que les composantes directionnelles coïncident avec une verticale de surface dans chaque cas.

2. Dispositif selon la revendication 1, caractérisé en ce que le corps piézoélectrique est en forme de cube.

3. Dispositif selon la revendication 1, caractérisé en ce que les fibres de détection (3a-c) est [sic] fixées parallèlement à une diagonale de face du corps piézoélectrique (12).

4. Dispositif selon la revendication 1, caractérisé en ce que le matériau est un semiconducteur composé III-V.

**5.** Dispositif selon la revendication 4, caractérisé en ce que le matériau est un quartz d'un groupe comprend [sic] GaAs, InAs, InP, ZnSe, GaP.

**6.** Dispositif selon la revendication 1, caractérisé en ce que le matériau est un quartz d'un groupe comprenant le phosphate acide de potassium, le phosphate acide de rubidium, le phosphate acide d'ammonium.

**7.** Dispositif selon la revendication 1, caractérisé en ce que le moyen interférométrique comprend un interféromètre de Mach-Zehnder.

**8.** Dispositif selon la revendication 1, caractérisé en ce que précisément trois éléments piézoélectriques de détection, mutuellement perpendiculaires dans chaque cas, reçoivent les composantes directionnelles assignées.

FIG.1

FIG.2

FIG.3

FIG.4

FIG.5

FIG.7

FIG.6